Europäisches Patentamt

European Patent Office

Office européen des brevets

(19)

(11) Veröffentlichungsnummer: **0 075 919**

**A2**

(12) # EUROPÄISCHE PATENTANMELDUNG

(21) Anmeldenummer: 82108940.6

(22) Anmeldetag: 27.09.82

(51) Int. Cl.³: **G 11 C 11/24**
**G 11 C 11/40**

(30) Priorität: 28.09.81 DE 3138549

(43) Veröffentlichungstag der Anmeldung:
06.04.83 Patentblatt 83/14

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Goetz, Jürgen, Rolf, Dr. Dipl.-Phys.
Finkenweg 3
D-8059 Oberneuching(DE)

(54) Schaltungsanordnung zur Ankopplung von Lese-Flip-Flops an Bit-Leitungen in dynamischen Halbleiter-Schreib-Lese-Speichern.

(57) Bei einer Schaltungsanordnung zur Ankopplung von Lese-Flip-Flops ($T_1$, $T_2$) an Bit-Leitungen (4,4') in Halbleiter-RAM's ist zur Verkürzung der Zugriffszeit den die Flip-Flop-Knoten an die Bit-Leitungen (4,4') koppelnden Transistoren ($T_3$, $T_4$) jeweils ein Transistor ($T_5$, $T_6$) parallel geschaltet, der während der Informationsbewertung hochohmig und nach erfolgter Informationsbewertung niederohmig geschaltet ist.

FIG 1

EP 0 075 919 A2

## Schaltungsanordnung zur Ankopplung von Lese-Flip-Flops an Bit-Leitungen in dynamischen Halbleiter-Schreib-Lese-Speichern

Die vorliegende Erfindung betrifft eine Schaltungsanordnung zur Ankopplung von Lese-Flip-Flops an Bit-Leitungen in dynamischen Halbleiter-Schreib-Lese-Speichern mit jewils einem, einen Knoten des Lese-Flip-Flops an eine Bit-Leitung koppelnden Transistor.

Dynamische Halbleiter-Schreib-Lese-Speicher (RAM's) mit einer Kopplung der vorgenannten Art zwischen Lese-Flip-Flop und Bit-Leitungen ist beispielsweise aus "1977 IEEE International Solid-State Circuits Conference, Digest of Technical Papers", Vol. XX, Seiten 12 und 13 bekannt.

Bei derartigen Speichern werden bei einem Lesevorgang zunächst die Bit-Leitungen auf ein bestimmtes Potential vorgeladen, wobei die genannten Koppeltransistoren durchgeschaltet sind, so daß auch die Knoten des Lese-Flip-Flops auf das Bit-Leitungs-Potential vorgeladen werden. Gleichzeitig wird dabei der Fußpunkt des Lese-Flip-Flops über einen Takt auf einen hohen Potentialpegel gelegt, so daß das Flip-Flop in einer neutralen Stellung gehalten wird und damit nicht in eine Vorzugslage kippen kann. Sodann wird auf einer Seite des Flip-Flops eine eine Information enthaltende Speicherzelle und auf der anderen Seite des Flip-Flops eine Referenz-Zelle (Dummy-Zelle) angewählt, wodurch den Vorladepotentialen an den Knoten des Flip-Flops entsprechende Informationspotentiale über-

Lz 1 Kth    / 28.9.1981

0075919

lagert werden. Der Takt am Fußpunkt des Flip-Flops wird auf einen tiefen Pegel (üblicherweise Null-Pegel) und der Takt an den Koppeltransistoren zur Entkopplung von Bit-Leitungen und Flip-Flop-Knoten auf einen tieferen Pegel abgesenkt. Aufgrund der unterschiedlichen Informationspotentiale kippt das Flip-Flop nunmehr in eine seiner Vorzugslagen. Die entsprechende Information von den Knoten des Flip-Flops wird über entsprechende Transfertransistoren auf externe Bit-Leitungen gekoppelt, über welche die Information aus dem Speicher ausgegeben wird.

Der vorstehend erläuterte Vorgang des Kippens des Lese-Flip-Flops in eine Vorzugslage bedeutet mit anderen Worten, daß ein Flip-Flop-Zweig leitend wird und damit der entsprechende Knoten auf einen tiefen Pegel (Null-Potential) gezogen wird. Entsprechend müssen natürlich auch die interne Bit-Leitung (das ist diejenige Leitung, welche den Flip-Flop-Knoten mit den Speicherzellen verbindet) als auch die vorgenannte externe Bit-Leitung entladen, das heißt, auf einen tiefen Pegel (Null-Potential) gezogen werden. Die Zugriffszeit des Speichers wird damit unter anderem durch die Zeit bestimmt, die zur Entladung der externen und der internen Bit-Leitung nach erfolgter Informationsbewertung an den Flip-Flop-Knoten nötig ist.

Der vorliegenden Erfindung liegt die Aufgabe zugrunde, eine Möglichkeit zur Reduzierung der Entladungszeit der Bit-Leitungen und damit der Zugriffszeit zum Speicher anzugeben.

Diese Aufgabe wird bei einer Schaltungsanordnung der eingangs genannten Art erfindungsgemäß dadurch gelöst, daß dem jeweiligen Koppeltransistor ein weiterer Transistor parallel geschaltet ist und daß der weitere Transistor in einem Lesezyklus während der Informationsbewertung hochohmig und nach erfolgter Informationsbewertung niederohmig geschaltet ist.

In Weiterbildung der Erfindung werden die weiteren Transistoren durch ein Taktsignal angesteuert, das nach dem Absenken eines Fußpunkttaktes des Lese-Flip-Flops auf einen Tiefenpegel und nach Absenken des Pegels eines die Koppeltransistoren ansteuernden Taktes von einem hohen auf einen tieferen Pegel und vor dem erneuten Anheben des Fußpunkttaktes und des die Koppeltransistoren ansteuernden Taktes auf ihrem hohen Pegel wieder auf den tiefen Pegel abgesenkt wird.

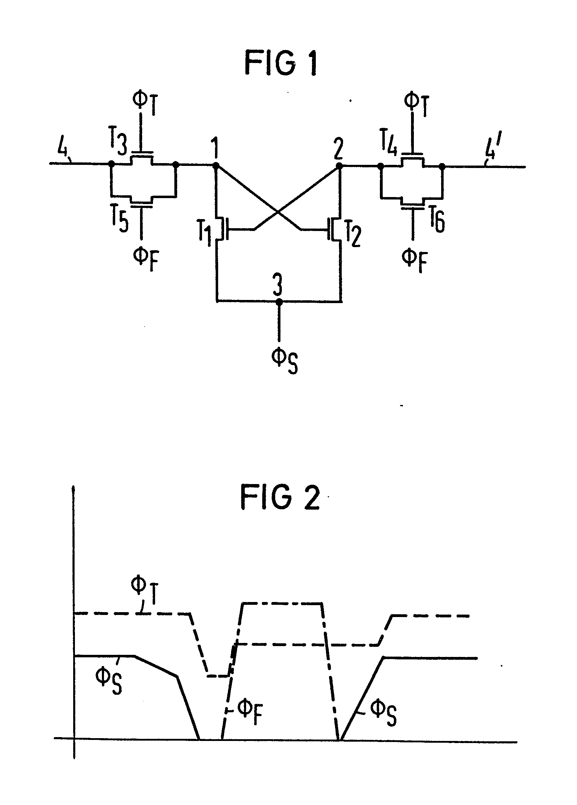

Die Erfindung wird im folgenden anhand eines Ausführungsbeispiels gemäß den Figuren 1 und 2 der Zeichnung näher erläutert. Es zeigt:
Fig. 1 ein Prinzipschaltbild eines Lese-Flip-Flops und dessen Ankopplung an interne Bit-Leitungen eines Speichers; und
Fig. 2 ein Zeitdiagramm von Taktsignalen zur Steuerung an verschiedenen Punkten der Schaltung nach Fig. 1.

Gemäß Fig. 1 wird ein Lese-Flip-Flop durch zwei kreuzgekoppelte Transistoren $T_1$ und $T_2$ mit zwei Bewerterknoten 1 und 2 sowie einem Fußpunkt 3 gebildet. An diesem Fußpunkt 3 wird dabei ein Takt $\emptyset_S$ eingespeist, der einen zeitichen Verlauf gemäß dem ausgezogen dargestellten Zeitdiagramm nach Fig. 2 besitzt.

Die Knoten 1 und 2 des Flip-Flops sind über jeweils einen Koppeltransistor $T_3$ und $T_4$ an interne Bit-Leitungen 4 und 4' des Speichers angekoppelt. Die Transistoren $T_3$ und $T_4$ werden durch einen Takt $\emptyset_T$ angesteuert, der einen in Fig. 2 als gestrichelte Kurve dargestellten Verlauf besitzt.

Wie eingangs bereits ausgeführt, werden für die Informationsbewertung durch das Flip-Flop der Takt $\emptyset_S$ auf einen Null-Pegel und der Takt $\emptyset_T$ auf einen tieferen, von Null verschiedenen Pegel abgesenkt.

Da der Takt $\emptyset_T$ in der Praxis vom Takt $\emptyset_S$ abhängig ist, steigt er nach der Informationsbewertung am Flip-Flop nicht auf seinen ursprünglichen hohen Pegel, wie dies aus dem Zeitdiagramm nach Fig. 2 ersichtlich ist. Die Transistoren $T_3$ und $T_4$ leiten daher nicht voll, wie dies für eine schnelle Entladung der internen und externen Bit-Leitung erforderlich wäre, die an den Knoten des Flip-Flops angekoppelt ist, dessen Transistor leitend geschaltet ist. Um diesen Nachteil zu vermeiden, ist nun erfindungsgemäß dem Koppeltransistor $T_3$ und dem Koppeltransistor $T_4$ jeweils ein Transistor $T_5$ und $T_6$ parallel geschaltet, die durch einen Takt $\emptyset_F$ gemäß der im Zeitdiagramm nach Fig. 2 strichpunktiert dargestellten Kurve angesteuert werden. Die Transistoren $T_5$ und $T_6$ sind daher während der Informationsbewertung durch das Flip-Flop hochohmig und nach erfolgter Informationsbewertung niederohmig, d.h., voll leitend, so daß die entsprechende Bit-Leitung schneller über den entprechenden Transistor $T_5$ bzw. $T_6$ entladen werden kann. Wie aus dem Zeitdiagramm nach Fig. 2 ersichtlich ist, wird der Takt $\emptyset_F$ nach dem Absenken des Taktes $\emptyset_S$ am Fußpunkt 3 des Flip-Flops auf einen tiefen Pegel und nach Absenken des Pegels des die Koppeltransistoren $T_3$ und $T_4$ ansteuernden Taktes $\emptyset_T$ von einem hohen auf einen tieferen Pegel und vor dem erneuten Anheben des Taktes $\emptyset_S$ und des Taktes $\emptyset_T$ auf ihren hohen Pegel wieder auf den tiefen Pegel abgesenkt.

2 Figuren
2 Patentansprüche

**0075919**

<u>Patentansprüche</u>

1. Schaltungsanordnung zur Ankopplung von Lese-Flip-Flops an Bit-Leitungen in dynamischen Halbleiter-Schreib-Lesespeichern mit jeweils einem, einen Knoten des Lese-Flip-Flops an eine Bit-Leitung koppelnden Transistor, d a d u r c h   g e k e n n z e i c h n e t, daß dem jeweiligen Koppeltransistor ($T_3$, $T_4$) ein weiterer Transistor ($T_5$ bzw. $T_6$) parallel geschaltet ist, und daß der weitere Transistor ($T_5$ bzw. $T_6$) in einem Lesezyklus während der Informationsbewertung hochohmig und nach erfolgter Informationsbewertung niederohmig geschaltet ist.

2. Schaltungsanordnung nach Anspruch 1, g e k e n n z e i c h n e t  durch ein Taktsignal ($\emptyset_F$) zu Ansteuerung der weiteren Transistoren ($T_5$, $T_6$), das nach dem Absenken eines Fußpunkttaktes ($\emptyset_S$) des Lese-Flip-Flops auf einen tiefen Pegel und nach Absenken des Pegels eines die Koppeltransistoren ($T_3$, $T_4$) ansteuernden Taktes ($\emptyset_T$) von einem hohen auf einen tieferen Pegel und vor dem erneuten Anheben des Fußpunkttaktes ($\emptyset_S$) und des die Koppeltransistoren ($T_3$, $T_4$) ansteuernden Taktes ($\emptyset_T$) auf ihren hohen Pegel wieder auf den tiefen Pegel abgesenkt wird.

FIG 1

FIG 2